# EUROPEAN PATENT APPLICATION

(11) **EP 2 434 534 A1**
(43) Date of publication of application: **28.03.2012**
(21) Application number: 10777650.2
(22) Date of filing: 22.04.2010
(51) Int. Cl.: H01L 21/28, H01L 21/336, H01L 21/337, H01L 21/768, H01L 29/12, H01L 29/417, H01L 29/78, H01L 29/808

(54) **SEMICONDUCTOR DEVICE AND METHOD OF PRODUCING SAME**

(30) Priority: 22.05.2009 JP 2009124617
(71) Applicant: Sumitomo Electric Industries, Ltd., Chuo-ku Osaka-shi Osaka 541-0041 (JP)
(72) Inventor: WADA, Keiji, Osaka-shi Osaka 554-0024 (JP); TAMASO, Hideto, Osaka-shi Osaka 554-0024 (JP); MASUDA, Takeyoshi, Osaka-shi Osaka 554-0024 (JP); HONAGA, Misako, Osaka-shi Osaka 554-0024 (JP)
(74) Representative: Grünecker, Kinkeldey, Stockmair & Schwanhäusser
(86) International application number: PCT/JP2010/057112
(87) International publication number: WO 2010/134415

(57) **Abstract**

A semiconductor device employing silicon carbide, and the like are provided. In the semiconductor device, even when an electrode material and an upper electrode material are different, a problem does not take place at an interface at which these different types of metals are in contact with each other, thus obtaining high reliability in long-term use.

The semiconductor device includes: a contact electrode 16 in contact with silicon carbides 14, 18; and an upper electrode 19 electrically conductive to the contact electrode. The contact electrode 16 is formed of an alloy including titanium, aluminum, and silicon, the upper electrode 19 is formed of aluminum or an aluminum alloy, and the upper electrode achieves the electric conduction to the contact electrode with the upper electrode making contact with the contact electrode.

## Description

### TECHNICAL FIELD

The present invention relates to a semiconductor device and a method for manufacturing the semiconductor device. More specifically, the present invention relates to a semiconductor device which employs silicon carbide as a semiconductor, is capable of stably maintaining low electric resistance for a long time, and includes an electrode and an upper electrode, as well as a method for manufacturing such a semiconductor device.

### BACKGROUND ART

In order to achieve high withstand voltage and low loss in a semiconductor device and utilization thereof under a high temperature environment, development of semiconductor devices employing silicon carbide (SiC) has been conducted. In particular, a switching element for a large current is required to achieve high withstand voltage and low loss. Accordingly, development of vertical type switching elements employing silicon carbide, particularly, vertical type MOSFETs (Metal Oxide Semiconductor Field Effect Transistors) or JFETs (Junction Field Effect Transistors) has been conducted.

In each of the vertical type MOSFETs employing SiC, a substrate material including a semiconductor, a gate oxide film, and the like has a front-side surface and a back-side surface, on each of which an electrode wire structure is formed. In the case of using SiC, electrode materials used for formation of electrodes and allowing for reduced contact resistance have not been sufficiently found, as compared with a case of using silicon, which has been used commonly and traditionally. However, n type SiC attains ohmic contact with nickel silicide obtained by subjecting a Ni (nickel) based electrode material to alloying heat treatment (heat treatment at approximately 1000°C) for silicidation. On the other hand, for p type SiC, contact resistance can be suppressed to be low with Ti (titanium)/Al (aluminum) or an AlSi alloy (Non-Patent Document 1).

In a vertical type MOSFET of SiC for use in controlling a large current, ohmic contact therewith is usually achieved using a Ni based or NiSi based material for a source electrode to be disposed in a source region of n type SiC. This conforms to the disclosure of the above-described Non-Patent Document. In one chip, a multiplicity of units each constituting a MOSFET are arranged in parallel and forms a predetermined electric circuit using internal upper electrodes. In a conventional silicon semiconductor device, for example, Al is used for an ohmic electrode material and can be also used for an internal upper electrode. However, in the case of SiC. it is difficult to use Al for both an ohmic electrode and an internal upper electrode because good ohmic contact between SiC and Al is hardly obtained at a temperature not more than the melting point of Al. Further, the above-described Ni based or NiSi based material is not used for an internal upper electrode because each of them is not so low in electric resistance and it is difficult to obtain an appropriate upper electrode material using the Ni based or NiSi based material. In addition, the Ni based material is less likely to achieve good ohmic contact with p type SiC. In the SiC semiconductor device, for the internal upper electrode, an Al based material (such as Al. AlSi alloy, or AlSiCu alloy) is frequently used. In this case, when used for a long time, the Al based material thus used for the internal upper electrode and the Ni based or NiSi based material used for the electrode may cause generation of an intermetallic compound having a high electric resistance, such as NiAl₃ (Non-Patent Document 2).

### PRIOR ART DOCUMENTS

### PATENT DOCUMENTS

Non-Patent Document 1: Satoshi Tanimoto, et al., "Practical Device-Directed Ohmic Contacts on 4H-SiC". Transactions of the Institute of Electronics, Information and Communication Engineers, the Institute of Electronics, Information and Communication Engineers, April, 2003, Vol.J86-C, No.4, pp.359-367

Non-Patent Document 2: Satoshi Tanimoto, et al. "High Temperature Highly Reliable Ohmic Contact for 4H-SiC Power Devices with Al Interconnects". Extended Abstracts of The Autumn Meeting, The Japan Society of Applied Physics, 5a-ZN-10, September, 2007, p.420

### SUMMARY OF THE INVENTION

### PROBLEMS TO BE SOLVED BY THE INVENTION

As described above, when the electrode material and the material for the internal upper electrode are different types of metals, problems may arise in resistance at an interface where the different types of metal materials are in contact with each other; durability of the contact portion in long-term use; and the like. An object of the present invention is to provide a semiconductor device employing silicon carbide and allowing for high reliability (maintenance of initially low electric resistance or the like) even in long-term use without any problem taking place in a contact portion of different types of metals, i.e., an electrode material and an internal upper electrode material which are different from each other.

### MEANS FOR SOLVING THE PROBLEMS

A semiconductor device of the present invention employs silicon carbide, and includes a contact electrode; and an upper electrode electrically conductive to the contact electrode. In the semiconductor device, the contact electrode is formed of an alloy including titanium, aluminum, and silicon, and is in contact with the silicon carbide. The upper electrode is formed of aluminum or an aluminum alloy, and achieves the electric conduction to the contact electrode with the upper electrode making contact with the contact electrode.

According to the above-described configuration, the alloy including titanium, aluminum, and silicon (hereinafter, referred to as "TiAlSi alloy") and the aluminum or aluminum alloy (AlSi alloy. AlSiCu alloy, or the like) are in direct contact with each other, thereby bringing the contact electrode and the upper electrode into an electrically conductive state. The TiAlSi alloy and the Al, AlSi alloy, or AlSiCu alloy are less likely to generate an intermetallic compound, which causes increase in electric resistance. The silicon carbide is good in heat resistance, and is therefore frequently used to deal with a large current, and is utilized in an environment of high temperature resulting from heat generated therefrom or other factors. Hence, depending on a combination of an electrode material and an upper electrode material, an intermetallic compound causing increase in electric resistance may be generated. However, the foregoing combination of the electrode material and the upper electrode material does not cause generation of such an intermetallic compound causing increase in electric resistance even when used for a long time in a high temperature. Accordingly, the low electric resistance thereof can be maintained, and stable and continuous usage thereof is attained.

Here, the TiAlSi alloy can include an additional element such as C, which is introduced during the manufacturing of the semiconductor device.

A barrier layer can be provided between the contact electrode and the upper electrode so as not to allow the contact electrode and the upper electrode to be directly in contact with each other, and the electric conduction is achieved when the upper electrode and the contact electrode makes contact with the barrier layer. As described above, the above-described upper electrode material and the above-described upper electrode material are less likely to generate the intermetallic compound causing increase in electric resistance, but such a conductive barrier layer provided between the contact electrode and the upper electrode further reduces factors causing instability thereof. Further, adhesion between the contact electrode and the upper electrode can be improved when the barrier layer formed is thin to be several nm and is made of Ti or the like to improve the adhesion. In other words, a very thin layer provided for improvement in adhesion is supposed to be encompassed in the barrier layer.

The barrier layer is formed of one of titanium (Ti), tantalum (Ta), tungsten (W), niobium (Nb), vanadium (V), zirconium (Zr), titanium nitride, tantalum nitride, tungsten nitride, niobium nitride, vanadium nitride, zirconium nitride, titanium silicide, tantalum silicide, tungsten silicide, niobium silicide, vanadium silicide, and zirconium silicide. By using each of these materials for the barrier layer, the following effects (1)-(4) can be obtained in addition to an effect of blocking elements of the electrode material or the upper electrode material from being diffused to cause generation of the intermetallic compound:
(1) Improved adhesion between the contact electrode and the upper electrode (in this case, the barrier layer usually has a thin film thickness of several nm to several ten nm);
(2) Improved workability resulting from improved selectivity in anisotropic etching;
(3) Suppression of distortion caused by a difference in coefficient of thermal expansion therebetween, and
(4) Improved electromigration resistance.

The contact electrode described above is capable of ohmic contact with the silicon carbide. Accordingly, the contact electrode can be disposed in a predetermined silicon carbide region with a low contact resistance.

The contact electrode can be in ohmic contact with both an n type region and a p type region of the silicon carbide. Accordingly, resist pattern formation do not need to be performed a plurality of times onto the regions having different conductive types, i.e., the resist pattern formation can be performed only once thereonto. This reduces dimensional errors resulting from the resist pattern formation performed a plurality of times, thereby achieving improved dimensional accuracy, improved yield, and the like.

The semiconductor device can be configured as a MOSFET in which the contact electrode is a source electrode or a drain electrode, when the contact electrode is the source electrode, the source electrode is in contact with both a source region and a contact region for an inversion portion formation region having a conductive type opposite to that of the source region, and the upper electrode is an upper source internal electrode or an upper drain electrode. This allows high reliability to be maintained for a long time, and allows for reduction of dimensional errors caused by the resist pattern formation, thereby achieving improved dimensional accuracy, improved yield, and the like.

The semiconductor device can be configured as a JFET in which the contact electrode is each of a source electrode, a gate electrode, and a drain electrode, and the upper electrode is each of an upper source electrode, an upper gate electrode, and an upper drain electrode. Accordingly, the same contact electrode material and upper electrode material can be used for all of the source, gate, and drain. As a result, the number of time of performing the resist pattern formation is reduced, which leads to reduced manufacturing cost. Further, dimensional errors resulting from the resist pattern formation performed a plurality of times can be reduced, thereby achieving improved dimensional accuracy, improved yield, and the like.

A method of the present invention for manufacturing a semiconductor device includes the steps of: preparing a substrate; forming a silicon carbide epitaxial layer on the substrate; forming an electrode formed of an alloy including titanium, aluminum, and silicon, on and in ohmic contact with the silicon carbide epitaxial layer; and providing an upper electrode formed of aluminum or an aluminum alloy, in contact with the electrode.

According to the method, the junction of the upper electrode and the electrode having a low contact resistance can be maintained at the low electric resistance for a long time. In other words, the electrode material and the upper electrode material can be prevented from reacting to each other, thus preventing generation of the intermetallic compound causing increase in electric resistance.

In the step of forming the electrode, after forming a titanium layer on the silicon carbide epitaxial layer, then an aluminum layer on the titanium layer, and then a silicon layer on the aluminum layer, or after forming a mixed layer of titanium, aluminum, and silicon on the silicon carbide epitaxial layer, heat treatment is performed for alloying thereof. In this way, an electrode having a low contact resistance for the silicon carbide can be securely obtained.

The method for manufacturing the semiconductor device further includes the step of: forming a barrier layer in contact with the electrode formed of the alloy, after forming the electrode formed of the alloy and before providing the upper electrode, wherein said upper electrode is provided in contact with the barrier layer. Even when there is provided no barrier layer, resistance in the interface (between the electrode and the upper electrode) can be sufficiently low for a long time. However, the barrier layer provided as described above can block an element of the electrode material or the upper electrode material from being diffused to cause generation of the intermetallic compound. A particular material such as titanium or titanium nitride is used for the barrier layer. Accordingly, at least one of the following effects (1)-(4) can be achieved: (1) improved adhesion between the contact electrode and the upper electrode (in this case, the barrier layer usually has a thin film thickness of several nm to several ten nm); (2) improved workability resulting from improved selectivity in anisotropic etching; (3) suppression of distortion caused by a difference in coefficient of thermal expansion therebetween; and (4) improved electromigration resistance.

Before or after forming the silicon carbide epitaxial layer or before forming the electrode formed of the alloy, an n type region and a p type region of the silicon carbide can be formed in the silicon carbide epitaxial layer and the electrode formed of the alloy can be formed in ohmic contact with both the n type region and the p type region. Accordingly, while reducing the number of process steps for the manufacturing, decrease in dimensional accuracy resulting from the resist pattern formation can be avoided. This leads to reduced manufacturing cost, improved dimensional accuracy, improved manufacturing yield, and the like.

There are two or more electrodes formed of the alloy. First, after forming the silicon carbide epitaxial layer and before forming the electrodes formed of the alloy, an n type region and a p type region of the silicon carbide are formed in the silicon carbide epitaxial layer. Then, among the electrodes, a first electrode formed of the alloy and to be in ohmic contact with the n type region and a second electrode formed of the alloy and to be in ohmic contact with the p type region can be formed using the same material at the same processing timing. In this way, improved dimensional accuracy, improved manufacturing yield, and the like can be achieved while reducing manufacturing cost, as described above.

### EFFECTS OF THE INVENTION

According to the present invention, a semiconductor device employing silicon carbide, and the like are provided in which even when an electrode material and an internal upper electrode material are different, a problem does not takes place at an interface at which these different types of metals are in contact with each other, thus attaining high reliability (maintenance of initially low electric resistance, or the like) in long-term use.

### BRIEF DESCRIPTION OF THE DRAWINGS

Fig. 1 is a cross sectional view showing a MOSFET, which is a semiconductor device in a first embodiment of the present invention.
Fig. 2 is a flowchart for a method for manufacturing the MOSFET shown in Fig. 1.
Fig. 3 is a flowchart for a method for manufacturing a contact electrode and an upper electrode to be in ohmic contact with silicon carbide.
Fig. 4 shows that in the manufacturing of the MOSFET shown in Fig. 1. a gate electrode is formed on a thermal oxide film, which is to serve as a gate oxide film.
Fig. 5 shows a state in which an interlayer insulating film is deposited.
Fig. 6 shows that a resist pattern is formed, then selective etching is employed to remove portions of the interlayer insulating film and the thermal oxide film in regions in which source contact electrodes are to be formed, and thereafter source contact electrodes are formed.
Fig. 7 shows that after removing the resist pattern, a drain electrode is formed on the back-side surface of the SiC substrate and then alloying treatment is performed.
Fig. 8 shows that an upper source internal electrode is formed in contact with the source contact electrode.
Fig. 9 is a cross sectional view showing a MOSFET, which is a semiconductor device in a second embodiment of the present invention.
Fig. 10 is a cross sectional view showing a JFET. which is a semiconductor device in a third embodiment of the present invention.

### DESCRIPTION OF THE REFERENCE SIGNS

10: MOSFET; 11: n⁺ type SiC substrate; 11b: SiC substrate back-side surface; 12: n type SiC epitaxial layer (drift layer); 12a: surface of n type SiC epitaxial layer; 13: p body; 14: n⁺ type source region; 15: gate oxide film; 16: source contact electrode; 17: gate electrode; 18: p⁺ inversion layer contact region; 19: upper source internal electrode; 20: drain electrode; 21: interlayer insulating film; 23: thermal oxide film of back-side surface of SiC substrate; 29: passivation protecting film; 30: JFET; 31: SiC substrate: 32: first p type layer: 33: n type layer; 34: second p type layer; 35: n⁺ source region; 36: p⁺gate region; 37: n⁺ drain region; 38: oxide film; 39: source contact electrode; 41: gate contact electrode; 42: drain contact electrode; 43: p⁺ potential holding region; 44: contact electrode for potential holding region; 45: upper source electrode; 46: upper gate electrode; 47: upper drain electrode; 61: source electrode; 62: gate electrode; 63: drain electrode; 64: passivation film; 71: groove portion; 71a: groove portion bottom wall; 71b: groove portion side wall; 91: resist pattern; R: inversion layer.

### MODES FOR CARRYING OUT THE INVENTION

### (First Embodiment)

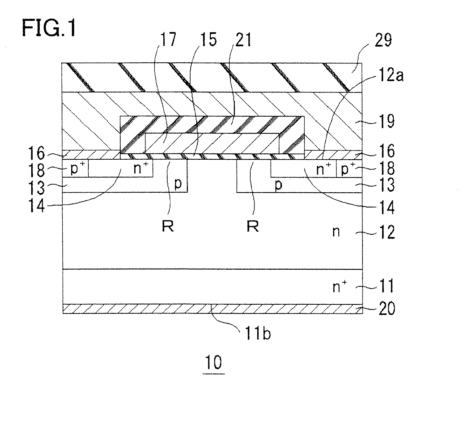

Fig. 1 is a cross sectional view showing a MOSFET, which is a semiconductor device in a first embodiment of the present invention. In the MOSFET of the present embodiment, silicon carbide (SiC) is used as a semiconductor. The MOSFET includes an n⁺ type SiC substrate 11. and an n type SiC layer (drift layer) 12 epitaxially grown thereon. N type SiC layer (drift layer) 12 has a thickness of 10 µm, and has an n type impurity concentration of approximately 1 × 10¹⁶cm⁻³. for example. SiC epitaxial layer 12 has a surface 12a in which p bodies 13, n⁺ SiC source regions 14, p⁺ SiC regions 18 respectively provided adjacent to source regions 14 are disposed. P bodies 13 are interposed between each of n⁺ source regions 14/p⁺ regions 18 and drift layer region 12.

A source contact electrode 16 is provided in contact with each of source regions 14 and each of p⁺ regions 18. An upper source internal electrode 19 is provided in contact with source contact electrode 16. A gate oxide film 15 is disposed on surface 12a of the SiC epitaxial layer including source regions 14/p bodies 13. Disposed on gate oxide film 15 is a polysilicon gate electrode 17, with added impurity, having a conductivity. Gate electrode 17 is covered with an interlayer insulating film 21 and is therefore insulated. On interlayer insulating film 21, an upper source internal electrode 19 is provided to be electrically conductive to source contact electrode 16. Upper source internal electrode 19 is covered with a passivation protecting film 29 and is therefore protected entirely. As described below, by forming or extinguishing n type inversion layers R within p bodies 13 just below gate oxide film 15, on/off is controlled for a large current flowing in source contact electrodes 16, inversion layers R, and drift layer region 12, and drain electrode 20. Through p⁺ regions 18, voltage is applied to each of p bodies 13. Such p⁺ regions 18 can be regarded as contact regions for inversion layer formation regions 13.

N⁺ SiC substrate 11 constitutes a drain region, and has a back-side surface 11b provided with a drain electrode 20.

Each of source contact electrodes 16 is formed of an alloy (TiAlSi alloy) including Ti, Al, and Si. Further, upper source internal electrode 19 is formed of Al or an Al alloy (AlSi alloy, AlSiCu alloy, or the like). If nickel (Ni) is used for source contact electrodes 16 as in the conventional arts, nickel may react with the Al or Al in the Al alloy usually used for the internal upper electrode, to generate an intermetallic compound having a high electric resistance, such as NiAl₃ In the present embodiment, the TiAlSi alloy is used for source contact electrodes 16. Accordingly, no intermetallic compound having a high electric resistance is generated even though upper source internal electrodes 19 are formed of Al or an Al alloy. Accordingly, high reliability can be maintained for a long time.

In a MOSFET having a DMOS (Double-Diffused MOSFET) structure, n⁺ source regions 14 and p bodies 13 need to be maintained at the same potential. Whence, source contact electrodes 16 are required to have reduced contact resistances and be electrically connected to both n⁺ source regions 14 and p⁺ regions 18. Moreover, in MOSFET 10, contact resistance between each of n⁺ source regions 14 and each of source contact electrodes 16 is required to be as low as possible, in order to achieve reduced on resistance. In the present embodiment, these requirements are satisfied by using the above-described TiAlSi alloy for source contact electrodes 16 and bringing source contact electrodes 16 into ohmic contact with both n⁺ source regions 14 and p⁺ regions 18. As a result, in MOSFET 10, the number of times of performing resist pattern formation can be reduced to improve dimensional accuracy. This leads to simplified manufacturing process, improved yield, and improved degree of integration.

In MOSFET 10, on-off control for a large current is performed as follows. When gate electrode 17 is fed with a voltage not more than a threshold value, inversion electrons are not induced in p bodies 13 just below gate oxide film 15. Thus, MOSFET 10 is in a non-conduction (off) state. When gate electrode 17 is fed with a voltage exceeding the threshold value, n type inversion layers R are formed in contact portions (thin layers) of p bodies 13 with gate oxide film 15. Accordingly, n-type inversion layers R thus formed provide electron flow paths connecting n⁺ source regions 14 to n type SiC drift layer region 12. This allows a large current to flow between the source and the drain.

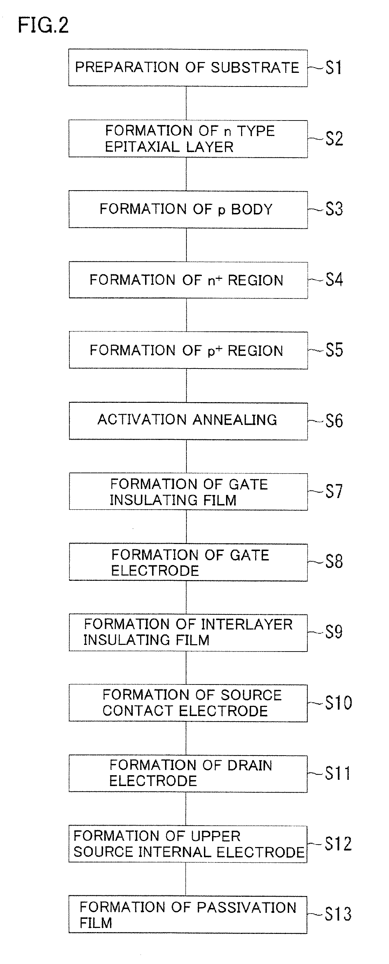

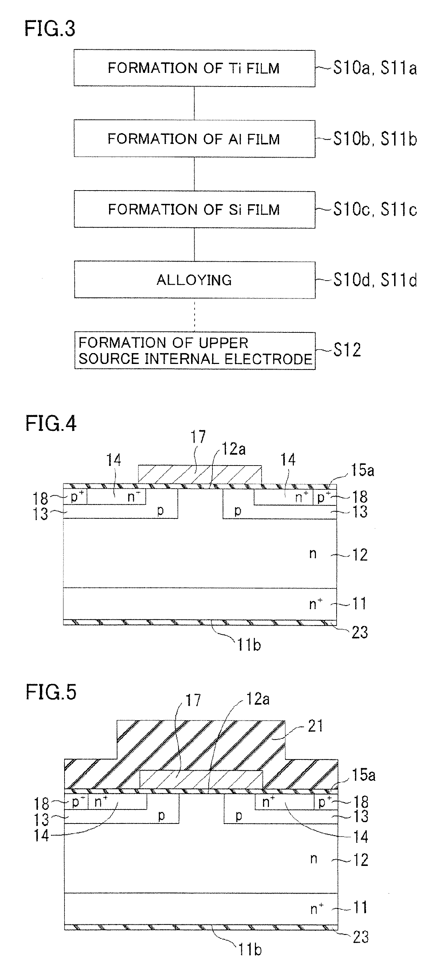

Fig. 2 is a flowchart showing a method for manufacturing MOSFET 10, which is the semiconductor device in the present embodiment. Fig. 3 is a flowchart showing a method for manufacturing each of source contact electrodes 16 and upper source internal electrode 19. Steps from preparation of n⁺ type SiC substrate 11 (step S1) to formation of gate insulating film 15 (step S7) can be performed using a well-known manufacturing method. Specifically, n⁺ type SiC substrate 11 is prepared (step S1). Then, n type SiC epitaxial layer 12, which is to serve as a drift layer, is formed on n⁺ type SiC substrate 11 (step S2). Then, p bodies 13 are formed in regions of n type SiC epitaxial layer 12 thus formed (step S3). Then, n⁺ regions 14, which are to serve as source regions, are formed (step S4). Then, p⁺ type regions 18 are formed (step S5). Then, activation annealing treatment is performed to heat it to approximately 1700°C in argon (Ar) atmosphere and maintain it for approximately 30 minutes (step S6). Then, a gate insulating film (thermal oxide film) 15a is formed (step S7).

In the formation of thermal oxide film15a (step S7), a thermal oxide film 23 is formed on back-side surface 11b of n⁺ type SiC substrate 11. Thermal oxide film 23 serves as a protecting film for n⁺ type SiC substrate 11.

Thereafter, gate electrode 17 is formed as shown in Fig. 4 (step S8). Gate electrode 17 is made of polysilicon, Al, or the like, and extends above one source region 14 and the other source region 14 with thermal oxide film 15a, which is to serve as the gate oxide film, interposed therebetween. When polysilicon is used as a raw material for the gate electrode, concentration of an impurity such as P therein is set to be high, specifically, to exceed 1 × 1 0²⁰ cm⁻³ in order to secure electron conductivity. The polysilicon film deposited may have a thickness of approximately 50 nm.

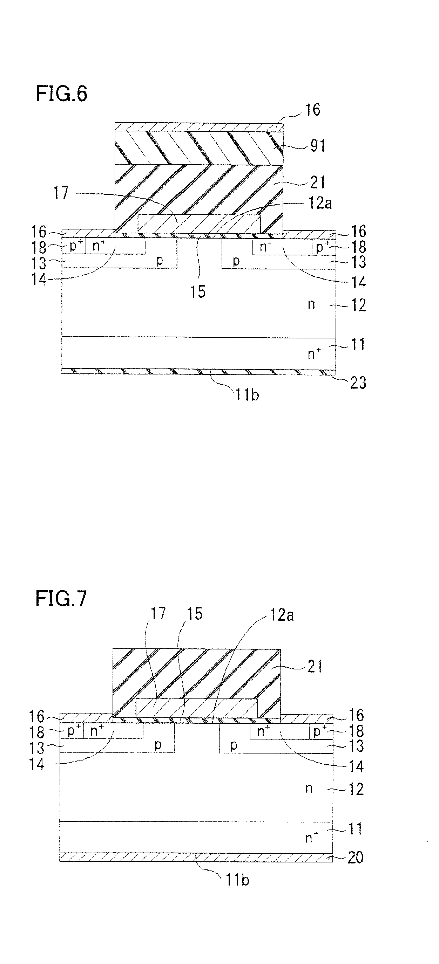

Thereafter, interlayer insulating film 21 is formed as shown in Fig. 5 (step S9). Interlayer insulating film 21 is formed to cover gate electrode 17 and oxide film 15a, using, for example, a CVD method. Interlayer insulating film 21 thus formed is constituted by a SiO₂ film having a thickness of approximately 1 µm. Next, as shown in Fig. 6, a resist pattern 91 is formed which has openings corresponding to regions in which source contact electrodes 16 are to be formed. Using resist pattern 91 as a mask, for example, RIE is employed to remove portions of interlayer insulating film 21 and gate oxide film 15a in the regions on which the source contact electrodes are to be formed, thereby exposing surface regions of the epitaxial layer at the portions on which the source contact electrodes are to be formed.

Then, as shown in Fig. 6, source contact electrodes 16 are formed (step S10). Then, resist pattern 91 is removed, thereby lifting off the layers deposited on the resist film upon the formation of the source contact electrodes. Then, back-side surface 11b of n⁺ type SiC substrate 11 is exposed and cleaned. Thereafter, as shown in Fig. 7, drain electrode 20 is formed using the same material as that of source contact electrodes 16 (step S11).

Specifically, both electrodes 16, 20 are formed of the TiAlSi alloy. Fig. 3 is a flowchart illustrating the manufacturing of these electrodes formed of the TiAISi alloy, more in detail. As shown in S10a or S11a to S10c or S11c of Fig. 3, a Ti film, an Al film, and a Si film are layered in this order on each of surface 12a of SiC epitaxial layer 12 and back-side surface 11b of SiC substrate 11. As a method for layering them, a sputtering method or the like may be used. Then, for example, in the formation of source contact electrodes 16, resist film 91 is removed as described above, thereby removing (lifting off) the Ti film, the Al film, and the Si film layered on the resist film. Accordingly, as shown in Fig. 7, the three-layer films each constituted by the Ti film, the Al film, and the Si film are left on surface 12a of SiC epitaxial layer 12 exposed from gate oxide film 15. and back-side surface 11b of SiC substrate 11.

Next, they are held for 10 minutes or shorter in an inert atmosphere such as Ar, at a temperature ranging from 550°C to 1200°C, preferably, at a temperature ranging from 900°C to 1100°C. For example, they are held at approximately 1000°C for two minutes (alloying treatment). This alloying treatment allows the Ti film, the Al film, the Si film, and SiC epitaxial layer 12 to be alloyed, thereby forming source contact electrodes 16 (step S10d). This alloying treatment also allows the Ti film, the A1 film, the Si film, and SiC substrate 11 to be alloyed, thereby forming drain electrode 20 (step S11d). Fig. 7 shows a state after source contact electrodes 16 and drain electrode 20 are subjected to the alloying treatment and are thus formed of the TiAlSi alloy.

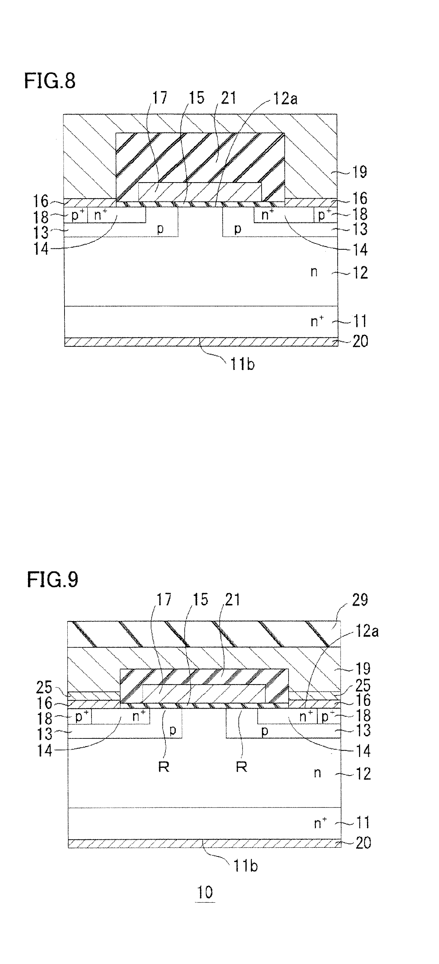

Next, as shown in Fig. 8, upper source internal electrode 19 is formed (step S12). In this case, on source contact electrode 16 thus formed of the TiAlSi alloy, there is formed upper source internal electrode 19 which is made of Al or an Al alloy that is an electrically conductive metal, using a vapor deposition method, for example. Due to the alloying treatment, the TiAlSi alloy serves as an electric conductor having a good electric conductivity. When the TiAlSi alloy is in contact with the Al or Al alloy, which has good electric conductivity, they achieve electric connection with low contact resistance. In other words, the contact between the TiAlSi alloy and the Al or Al alloy atttains contact with low electric resistance. In addition, unlike the conventional arts, Ni is not used as the material of the source contact electrodes making ohmic contact with the n type SiC region. Hence, an intermetallic compound having a high electric resistance such as NiAl₃ is not generated during use, unlike in the case of the contact between each source contact electrode of Ni and the upper source internal electrode of Al or Al alloy. As such, the combination of source contact electrodes 16 and upper source internal electrode 19 thus obtained allows low contact resistance to be maintained to be low for a long time.

On the wafer in the state of Fig. 8, passivation protecting film 29 is deposited, thereby obtaining semiconductor device 10 shown in Fig. 1.

As described above, MOSFET 10 employing SiC in the present embodiment has the following advantages:
(1) An intermetallic compound, which causes increase in electric resistance, is not generated even when used for a long time, due to the combination of source contact electrodes 16 made of the TiAlSi alloy and upper source internal electrode 19 made of Al or Al alloy for providing electric conduction to source contact electrodes 16. As a result, the source electrodes with low electric resistances can be stably maintained for a long time.
(2) The manufacturing process can be simplified because the one type of source contact electrodes 16 thus made of the TiAlSi alloy is capable of ohmic contact with both source n⁺ SiC regions 14 and p⁺ type regions 18. Further, the number of times of resist film formation is reduced, thereby achieving improved dimensional accuracy. The improved dimensional accuracy provides advantages such as improvement in degree of integration, improvement in yield, and improvement in quality.

Further, at the same time as the formation of source contact electrodes 16, n type drain electrode 20 can be formed using the TiAlSi alloy. This allows for simplified manufacturing process. In the present embodiment, the conductive types are determined so as to form an n channel, but the conductive types may be determined in a manner opposite to the foregoing case so as to form a p channel. Further, the conductivity of n⁺ SiC substrate 11 may be changed to p⁺ in MOSFET 10 to obtain an IGBT (Insulated Gate Bipolar Transistor).

### (Second Embodiment)

Fig. 9 shows a MOSFET employing SiC, which is a semiconductor device in a second embodiment of the present invention. A difference from the first embodiment lies in that a barrier layer 25 is provided between each of source contact electrodes 16 and upper source internal electrode 19. The other configurations are the same as those of the first embodiment. In the present invention, each of source contact electrodes 16 is formed of TiAlSi alloy, and upper source internal electrode 19 is formed of Al or an Al alloy. Both the metals do not react to each other to generate an intermetallic compound having a high electric resistance. Hence, barrier layer 25 is not much required to block diffusion of elements thereof. Accordingly, barrier layer 25 may be a Ti layer having a thickness of several nm in order to improve adhesion between each of source contact electrodes 16 and upper source internal electrode 19. Further, in order to accommodate to utilization in an environment of high temperature or the like and more securely prevent the reaction between each of source contact electrodes 16 and upper source internal electrode 19, barrier layer 25 may be a layer having a thickness of several ten nm to several thousand nm and made of the following material. That is, barrier layer 25 may be a layer made of at least one of titanium (Ti), tantalum (Ta), tungsten (W), niobium (Nb), vanadium (V), zirconium (Zr), titanium nitride, tantalum nitride, tungsten nitride, niobium nitride, vanadium nitride, zirconium nitride, titanium silicide, tantalum silicide, tungsten silicide, niobium silicide, vanadium silicide, and zirconium silicide.

The method for manufacturing the MOSFET differs from that of the first embodiment in steps as follows. After the formation of gate electrode 17 (step S8), the formation of interlayer insulating film 21 (step S9), and the formation of source contact electrodes 16 (and drain electrode 20) (step S10, S11), a resist pattern is formed for formation of barrier layers 25 on source contact electrodes 16. A film forming method therefor depends on a material to be used, but it is preferable to use sputtering for the film formation in the case of using a metal. On the other hand, in the case of using nitride or silicide, it is preferable to use the CVD method. In order to cover barrier layers 25 and interlayer insulating film 21, upper source internal electrode 19 can be provided.

By providing each barrier layer 25 between each source contact electrode 16 and upper source internal electrode 19 as described above, the following advantages can be obtained:
(1) Improvement in adhesion due to utilization of the thin Ti film or the like;
(2) Improvement in workability due to improvement in selectivity of etching such as RIE: and
(3) Suppression of thermal expansion difference between each of source contact electrodes 16 and upper source internal electrode 19.

### (Third Embodiment)

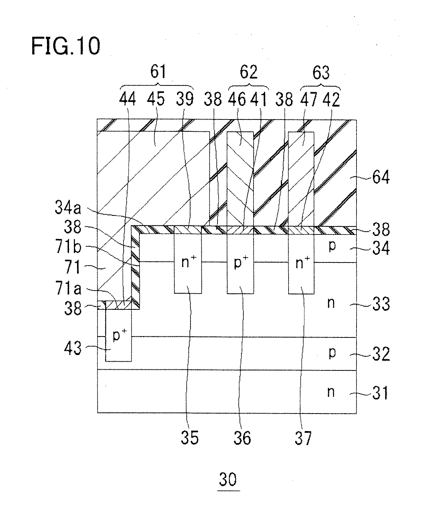

Fig. 10 is a cross sectional view showing a junction field effect transistor JFET 30, which is a semiconductor device in a third embodiment of the present invention. SiC-JFET 30 has a structure in which the following epitaxial layers are stacked: an n type substrate 31, a first p type layer 32, an n type layer 33, and a second p type layer 34.

First p type layer 32 may have a thickness of approximately 10 µm and have a p type impurity concentration of approximately 7.5 × 10¹⁵ cm⁻³, for example. N type layer 33 may have a thickness of approximately 0.45 µm and have an n type impurity concentration of approximately 2 × 10¹⁷cm⁻³, for example. Second p type layer 34 may have a thickness of approximately 0.25 µm and have a p type impurity concentration of approximately 2 × 10¹⁷ cm⁻³.

Regions 35, 36, 37 are provided which project from a surface 34a of second p type layer 34 into n type layer 33 through the second p type layer. The thickness of n type layer 33 between each bottom tip of regions 35, 36, 37 thus projecting and first p type layer 32 is sufficient.

The region located at the central portion to project downward (toward SiC substrate 31) is p⁺ type gate region 36, and is electrically connected to a gate contact electrode 41 and an upper gate electrode 46. Gate contact electrode 41 and upper gate electrode 46 constitute a gate electrode 62. Further, n⁺ drain region 37 is electrically connected to a drain contact electrode 42 and an upper drain electrode 47. Drain contact electrode 42 and upper drain electrode 47 constitute a drain electrode 63. N⁺ source region 35 is electrically connected to a source contact electrode 39 and an upper source electrode 45.

In each of n⁺ source region 35 and n⁺ drain region 37, n type impurity concentration is 1 × 10²⁰ cm⁻³, and is higher than that of n type layer 33 by several orders. In p⁺ gate region 36, for example, p type impurity concentration is 1 × 10¹⁸ cm⁻³, and is higher than those of first p type layer 32 and second p type layer 34 by several orders.

Further, in JFET 30, a groove portion 71 is provided adjacent to an end of n⁺ source region 35. A p⁺ potential holding region 43 is provided to project from a bottom portion 71a of groove portion 71 into first p type layer 32 through n type layer 33. Between the bottom tip of p⁺ potential holding region 43 and n type substrate 31, the thickness of first p type layer 32 is sufficient. P⁺potential holding region 43 is electrically connected to a potential holding contact electrode 44 and an upper source electrode 45. P⁺ potential holding region 43 has a p type impurity concentration of, for example, 1 × 10¹⁸CM⁻³. Source contact electrode 39, potential holding contact electrode 44, and upper source electrode 45 constitute a source electrode 61.

According to the structure of source electrode 61, n⁺ type source region 35 and p⁺ type potential holding region 43 are maintained at the same electric potential.

Respective locations between contact electrodes 44, 39, 41, 42 are covered with oxide films 38 to secure insulation between the contact electrodes. Locations between upper electrodes 45, 46, 47 are covered or filled with a passivation film 64, for example, a SiO₂ film, to secure insulation therebetween. Passivation film 64, which thus provides the insulation between upper electrodes 45, 46, 47, also provides insulation from outside and protects JFET 30 from an external environment.

The above-described contact electrodes, i.e., source contact electrode 39, contact electrode 44 in the potential holding region, gate contact electrode 41, and drain contact electrode 42 are all formed of the TiAlSi alloy described above. P⁺ drain region 36 has a conductivity of p type and n⁺ source region 35 and n⁺ drain region 37 have a conductivity of n type. Hence, if the n type and p type regions are formed using electrodes made of different materials as in the conventional arts, a very large number of process steps are required. For example, the following problem takes place if source contact electrode 39 and drain contact electrode 42 are formed of Ni and gate contact electrode 41 is formed to have a Ti/Al layered structure. That is, a mask for forming source contact electrode 39 and drain contact electrode 42 is formed and then contact electrodes 39, 42 are formed using vapor deposition or the like. Thereafter, the mask is removed, and then a mask for forming gate contact electrode 41 is formed. Thereafter, contact electrode 41 needs to be formed using vapor deposition or the like. If such a manufacturing process is adopted, the number of process steps is increased, and alignment errors take place upon forming the two masks. This results in decreased yield, decreased degree of integration, and the like. To counteract this, all the contact electrodes 39, 41, 42, 44 are formed of the same TiAlSi alloy. Hence, contact electrodes 39, 41, 42, 44 are formed collectively using only one mask formed. This achieves improvement of dimensional accuracy, improvement in yield, improvement in degree of integration, and the like.

Further, upper source electrode 45, upper gate electrode 46, and upper drain electrode 47 are all formed of the same Al or Al alloy. Accordingly, even when contact electrodes 39, 41, 42, 44 and upper electrodes 45, 46, 47 are used together for a long time, an intermetallic compound causing increase in electric resistance is not generated.

Referring to Fig. 10, there is a region interposed between p⁺ type gate region 36 and n⁺ type drain region 37. In n type layer 33 between the region thus interposed and first p type layer 32, a drift region is formed. Further, the region between p⁺ gate region 36 and first p type layer 32 serves as a channel region. When gate contact electrode 62 has a voltage of 0 V, a reverse bias voltage is not sufficiently applied to the pn junction. Accordingly, the drift region and the channel region are not depleted. Therefore, n⁺ source region 35 and n⁺ drain region 37 are electrically connected to each other (ON state). Thus, electrons travel from n⁺ source region 35 to n⁺ drain region 37.

When gate contact electrode 41 is fed with a negative voltage, a reverse bias voltage is sufficiently applied to the pn junction, which is an interface between p⁺ gate region 36 and n type layer 33. Accordingly, a depletion layer expands to n type layer 33, which has a lower impurity concentration. As a result, the channel region and the drift region are depleted and n⁺ source region 35 and n⁺ drain region 37 are therefore electrically disconnected from each other. Hence, no current flows (OFF state).

Using such a mechanism, JFFT 30 performs on-off control for the current.

JFET 30 shown in Fig. 10 is manufactured through process steps of manufacturing a well-known semiconductor device.

Groove portion 71 is a structure that is not provided in MOSFET 10 of the first embodiment, but can be formed therein by providing surface 34a of second p type layer 34 with a mask layer having an opening at a portion corresponding to groove portion 71, and dry-etehing it using SF₆ gas, for example.

Thereafter, the n⁺ souree region and the like are formed by means of ion injection. For example, n⁺ source region 35 and n⁺ drain region 37 are formed in the following manner as described in the first embodiment: an oxide film pattern is formed and then ion injection of an n type impurity is performed. For p⁺ gate region 36 and p⁺ potential holding region 43, different types of impurities are utilized but they are also ion-injected using an oxide film pattern as a mask. However, in the case where p potential holding region 43 formed in the groove portion has a depth shallower than that of p⁺ gate region 36, the ion injections are performed separately at different times. Thereafter, in an inert atmosphere such as argon, activation annealing treatment is performed at 1700°C for 30 minutes, as with the first and second embodiments.

Oxide film 38 is formed as a field oxide film by treatment of subjecting it to oxygen atmosphere at 1300°C for 30 minutes after the activation annealing treatment.

Thereafter, a resist pattern having openings at portions corresponding to the four contact electrodes 39, 41, 42, 44 is formed on oxide film 38. Using the resist pattern as a mask, portions of oxide film 38 at locations corresponding to the openings are removed by means of RIE or the like. Then, a TiAlSi mixed film is formed by means of mix sputtering, which sputters Ti, Al, and Si simultaneously. In the first and second embodiments, the Ti film, the Al film, and the Si film are layered. Then, the resist film is removed to lift off the TiAISi mixed film on the resist film. Thereafter, the TiAlSi mixed film is formed into a TiAlSi alloy by means of alloying treatment.

In the alloying treatment, the TiAlSi mixed film is heated in an inert atmosphere such as argon, at a temperature ranging from 550°C to 1200°C, preferably, at a temperature ranging from 900°C to 1100°C. For example, the TiAlSi mixed film is heated at 1000°C, and maintained for 10 minutes or shorter, for example, for 2 minutes. In the treatment, only one resist pattern is formed for the formation of the four contact electrodes 39, 41, 42, 44, each of which are to be in ohmic contact with the semiconductor layer serving as a base.

Then, upper source electrode 45, upper gate electrode 46, and upper drain electrode 47 are formed. These upper electrodes are formed by forming a resist pattern having openings at its portions corresponding to the upper electrodes to be formed, and then depositing Al or an Al alloy thereon. After the deposition of the Al or Al alloy, the resist pattern is removed, thereby lifting off the Al or Al alloy on the resist pattern.

According to the manufacturing method described above, the four contact electrodes 39, 41, 42, 44 are all formed of the TiAlSi alloy, whereas upper electrodes 45, 46, 47 are formed of Al or Al alloy. Accordingly, an intermetallic compound having high electric resistance such as NiAl₃ is not generated.

Although the embodiments of the present invention have been described, it should be considered that the embodiments disclosed herein are illustrative and the scope of the present invention is not limited to the embodiment of the invention. The scope of the present invention is defined by the scope of claims, and is intended to include any modifications within the scope and meaning equivalent to the terms of the claims.

### INDUSTRIAL APPLICABILITY

The present invention provides a semiconductor device and the like. The semiconductor device employs silicon carbide and achieves high reliability in long-term use without any problem taking place at an interface at which different types of metals for an electrode and for an upper electrode are in contact with each other in the semiconductor device (allows initially low electric resistance to be maintained in the contact portion). Further, TiAlSi alloy, which is used for a contact electrode, is capable of ohmic contact with both p type SiC and n type SiC. Accordingly, the number of times of resist pattern formation can be reduced as compared with a case where different contact electrode materials are employed for respective conductive types. This prevents dimensional accuracy from decreasing due to the resist pattern formation, thus achieving improved dimensional accuracy and improved manufacturing yield.

## Claims

1. A semiconductor device employing silicon carbide, comprising a contact electrode; and an upper electrode electrically conductive to said contact electrode,
said contact electrode being formed of an alloy including titanium, aluminum, and silicon, and being in contact with said silicon carbide,
said upper electrode being formed of aluminum or an aluminum alloy, and achieving the electric conduction to said contact electrode with said upper electrode making contact with said contact electrode.

2. The semiconductor device according to claim 1. wherein a barrier layer is provided between said contact electrode and said upper electrode so as not to allow said contact electrode and said upper electrode to be directly in contact with each other, and the electric conduction is achieved with said upper electrode and said contact electrode making contact with said barrier layer.

3. The semiconductor device according to claim 2, wherein said barrier layer is formed of one of titanium (Ti), tantalum (Ta), tungsten (W), niobium (Nb), vanadium (V), zirconium (Zr), titanium nitride, tantalum nitride, tungsten nitride, niobium nitride, vanadium nitride, zirconium nitride, titanium silicide, tantalum silicide, tungsten siticide, niobium silicide, vanadium silicide, and zirconium silicide.

4. The semiconductor device according to any one of claims 1-3, wherein said contact electrode is in ohmic contact with said silicon carbide.

5. The semiconductor device according to any one of claims 1-4, wherein said contact electrode is in ohmic contact with both an n type region and a p type region of said silicon carbide.

6. The semiconductor device according to any one of claims 1-5, wherein:
said semiconductor device is a MOSFET, and said contact electrode is a source electrode or a drain electrode,
when said contact electrode is the source electrode, said source electrode is in contact with both a source region and a contact region for an inversion portion formation region having a conductive type opposite to that of said source region, and
said upper electrode is an upper source internal electrode or an upper drain electrode.

7. The semiconductor device according to any one of claims 1-5, wherein said semiconductor device is a JFET, said contact electrode is each of a source electrode, a gate electrode, and a drain electrode, and said upper electrode is each of an upper source electrode, an upper gate electrode, and an upper drain electrode.

8. A method for manufacturing a semiconductor device, comprising the steps of:
preparing a substrate;
forming a silicon carbide epitaxial layer on said substrate;
forming an electrode formed of an alloy including titanium, aluminum, and silicon, on and in ohmic contact with said silicon carbide epitaxial layer; and
providing an upper electrode formed of aluminum or an aluminum alloy, in contact with said electrode.

9. The method for manufacturing the semiconductor device according to claim 8, wherein in the step of forming said electrode, after (1) forming a titanium layer on said silicon carbide epitaxial layer, then an aluminum layer on said titanium layer, and then a silicon layer on said aluminum layer, or (2) forming a mixed layer of titanium, aluminum, and silicon on said silicon carbide epitaxial layer, heat treatment is performed for alloying thereof.

10. The method for manufacturing the semiconductor device according to claim 8 or 9, further comprising the step of: forming a barrier layer in contact with said electrode formed of the alloy, after forming said electrode formed of the alloy and before providing said upper electrode, wherein said upper electrode is provided in contact with said barrier layer.

11. The method for manufacturing the semiconductor device according to any one of claims 8-10, wherein after forming said silicon carbide epitaxial layer and before forming said electrode formed of the alloy, an n type region and a p type region of the silicon carbide are formed in said silicon carbide epitaxial layer and said electrode formed of the alloy is formed in ohmic contact with both said n type region and said p type region.

12. The method for manufacturing the semiconductor device according to any one of claims 8-10, wherein:
there are two or more said electrodes formed of the alloy,
after forming said silicon carbide epitaxial layer and before forming said electrodes formed of the alloy, an n type region and a p type region of the silicon carbide are formed in said silicon carbide epitaxial layer, and
among said electrodes, a first electrode formed of the alloy and to be in ohmic contact with said n type region and a second electrode formed of the alloy and to be in ohmic contact with said p type region are formed using the same material at the same processing timing.
